# EUROPEAN PATENT APPLICATION

(11) **EP 2 605 624 A1**
(43) Date of publication of application: **19.06.2013**
(21) Application number: 12184784.2
(22) Date of filing: 18.09.2012
(51) Int. Cl.: H05K 1/02, H01B 7/08

(54) **Flexible flat cable**

(30) Priority: 15.12.2011 JP 2011274832
(71) Applicant: Hosiden Corporation, Yao-shi, Osaka 581-0071 (JP)
(72) Inventor: Kondo, Hayato, Osaka, Osaka 5810071 (JP)
(74) Representative: Lemcke, Brommer & Partner

(57) **Abstract**

A plurality of linear conductors (11) arranged in parallel with each other are covered from the upper and lower sides thereof by first and second insulator layers (12, 13). On the upper side of the first insulator layer (12), a first adjustment material layer (14) is formed with forming a predetermined gap relative to an end of the flat cable (1). And, at this gap, a reinforcement plate (18) is provided. A shield member (19) is provided for covering the upper side of the reinforcement plate (18) and a portion of the upper side of the first adjustment material layer (14). From the upper side of the shield member (19) to the upper side of the first adjustment material layer (14), a first shield layer (16) is provided in such a manner to expose the upper side of the portion of the shield member (19) where the reinforcement plate (18) is present. A second insulator layer (13) is configured to expose the conductors (11) at the end of the flat cable (1). The shield member (19) includes an impedance adjusting means (30).

## Description

### Background of the Invention

### Field of the Invention

The present invention relates to a flexible flat cable.

### Description of the Related Art

In recent years, a flexible flat cable (to be referred to as "a flat cable" hereinafter) is used in internal wiring of various electric devices and electronic instruments such as a computer. The flat cable, as being formed in a band-like shape, has good flexibility and provides easy handling of wiring thereof within the instrument. Further, as the flat cable has only a small cross sectional area, it is suitable for use in a small instrument also.

When such flat cable is to be used for high speed transmission, matching is needed between the impedance of the circuit and the impedance of the flat cable in order to avoid reduction in the signal transmission rate due to mismatch between the impedances. In particular, impedance change tends to occur due to the arrangement provided at the end of the flat cable for connection with a connector.

For overcoming the above problem, for instance, there has been proposed a flat cable comprising: a plurality of flat-plate like conductors spaced part from each other with a predetermined gap therebetween and arranged in parallel with each other; first and second insulator layers sandwiching and covering the plurality of conductors therebetween, with exposing portions of the opposed ends of the conductors for allowing contact thereof with predetermined signal terminals; a first adjustment material layer provided on the side of the first insulator layer opposite the plurality of conductors and having insulation property; a ground layer provided only at the end of the side of the first adjustment material layer opposite the first insulator layer and coming into contact with a ground terminal having the ground potential; and a first shield layer provided on the side of the first adjustment material layer opposite the first insulator layer and electrically conductive to the ground layer; wherein the first adjustment material layer adjusts such that at the end, the distance between the conductors and the first shield layer is equal to the distance between the conductors and the ground layer (see Japanese Patent No. 4363664).

In the flat cable disclosed in this Japanese Patent No. 4363664, with the first adjustment material layer, it is adjusted such that at the end, the distance between the conductors and the first shield layer is equal to the distance between the conductors and the ground layer. This arrangement restricts occurrence of change in the electrostatic capacitance at the end of the conductor, thus preventing reduction of the impedance at the end.

As described above, with the flat cable disclosed in this Japanese Patent No. 4363664 too, it is possible to maintain appropriate the impedance at the end of the flat cable. In the case of the flat cable disclosed in this Japanese Patent No. 4363664 , as described above, with the first adjustment material layer, the distance between the conductors and the first shield layer is rendered equal to the distance between the conductors and the ground layer. At the end of this flat cable, there is provided a reinforcement plate and the ground layer is provided on the inner side of this reinforcement plate. For this reason, as shown in Fig. 3 of Japanese Patent No. 4363664, a gap or displacement is formed between the conductor-side contact of the connector engaging this flat cable and the ground-side contact of the connector. With the presence of such gap/displacement as above, there can occur such inconvenience as easy inadvertent detachment of the connector.

On the other hand, if the ground layer is provided from the end of the flat cable, that is, from the position overlapped with the reinforcement plate, it becomes possible to place the conductor-side contact of the connector in agreement/alignment with the ground-side contact of the connector. In this case, however, there occurs impedance reduction at the position of the reinforcement plate.

The present invention has been made in view of the above-described state of the art. The object of the invention is to provide a flexible flat cable that allows easy adjustment of impedance at the end.

### Summary of the Invention

For accomplishing the above-noted object, according to the present invention, there is proposed a flexible flat cable comprising:
a first sheet-like insulator layer;
a second sheet-like insulator layer disposed in opposition to the first insulator layer;
a plurality of linear conductors disposed in parallel with each other between the first insulator layer and the second insulator layer;
a first adjustment material layer disposed on the side of the first insulator layer opposite the conductors and spaced from an end of the flexible flat cable with a predetermined distance;
a reinforcement plate provided on the side of the first insulator layer opposite the conductors and between the end of the flexible flat cable and the first adjustment material layer;
a shield member disposed so as to cover the side of the reinforcement plate opposite the first insulator layer and the side of the first adjustment material layer opposite the first insulator layer;
a first shield layer disposed from the side of the shield member opposite the reinforcement plate to the side of the first adjustment material layer opposite the first insulator layer, with exposing a portion of the side of the shield member opposite the reinforcement plate;
wherein the second insulator layer is arranged to expose the conductors at the end of the flexible flat cable;
the exposed conductors and the exposed shield member come into contact with signal terminals and a ground terminal of a connector; and
the shield member includes an impedance adjusting means.

With the above-described arrangement, the plurality of linear conductors arranged in parallel with each other are covered as being sandwiched between the first insulator layer and the second insulator layer. But, the second insulator layer does not cover the conductors along the entire lengths thereof, but leaves the conductors being exposed at the end of the flexible flat cable. And, the shield member too is exposed at the end of the flexible flat cable. Therefore, the signal terminals and the ground terminal of the connector can be arranged in opposition to each other. This prevents occurrence of easy inadvertent detachment of the connector. Further, as the shield member includes an impedance adjusting means, it is possible to adjust the impedance at the end of the flexible flat cable to a desired value.

The impedance adjusting means can be realized by e.g. decreasing the surface area of the side of the shield member opposite the reinforcement member. As the impedance depends on the surface area of the shield member, a desired impedance can be obtained by varying the area.

Depending on the method of manufacturing the flexible flat cable, there may be formed a gap between the shield member and the first adjustment material layer. In such case, when the shield member comes into contact with the first insulator layer at the portion of such gap, impedance reduction occurs at this gap portion. Therefore, according to one preferred embodiment of the present invention, a gap is formed between the reinforcement plate and the first adjustment material layer; the shield member comes into contact with the first insulator layer at the gap; and the rate of decrease in the area at the gap is set greater than the rate of decrease in the area at the portion of the shield member covering the reinforcement member.

With the above-described arrangement, with setting the area decrease rate of the shield member greater at the gap, impedance reduction at the gap portion can be restricted.

The decrease of the area of the shield member can be realized by e.g. forming a through hole extending through the shield member. As such through hole can be easily formed, a desired impedance can be obtained without inviting manufacture cost increase.

The through hole can be provided at various positions. Preferably, however, the through hole can be formed e.g. at the position overlapped with the conductor as seen in the plane view. With formation of the through hole in this manner, impedance adjustment can be further facilitated.

According to another preferred embodiment of the flexible flat cable of the present invention, the flexible flat cable further comprises:
a second adjustment material layer provided on the side of the second insulator layer opposite the conductors and spaced from the end of the flexible flat cable with a predetermined distance; and
a second shield layer provided on the side of the second adjustment material layer opposite the second insulator layer and spaced from the end of the flexible flat cable with a predetermined distance.

With the above-described arrangement, since the adjustment material layers and the shield layers are provided on the both sides of the conductors, impedance adjustment can be further facilitated.

### Brief Description of the Drawings

[Fig. 1] is a plane view showing a flexible flat cable according to an embodiment of the present invention as seen from the side of a second insulator layer,
[Fig. 2] is a section view showing the flexible flat cable according to the embodiment of the present invention,
[Fig. 3] is a plane view showing the flexible flat cable according to the embodiment of the present invention as seen from the side of a first insulator layer,
[Fig. 4] is a section view showing a flexible flat cable according to an embodiment of the present invention,
[Fig. 5] is a view showing impedances at different positions of the flexible flat cable,
[Fig. 6] is a view showing impedances at different positions of the flexible flat cable,
[Fig. 7] is a plane view showing a flexible flat cable according to an embodiment of the present invention as seen from the side of a first insulator layer,
[Fig. 8] is a plane view showing a flexible flat cable according to an embodiment of the present invention as seen from the side of a first insulator layer,
[Fig. 9] is a section view of a flexible flat cable according to a further embodiment of the present invention.

### Detailed Description of the Preferred Embodiments

### [General Configuration]

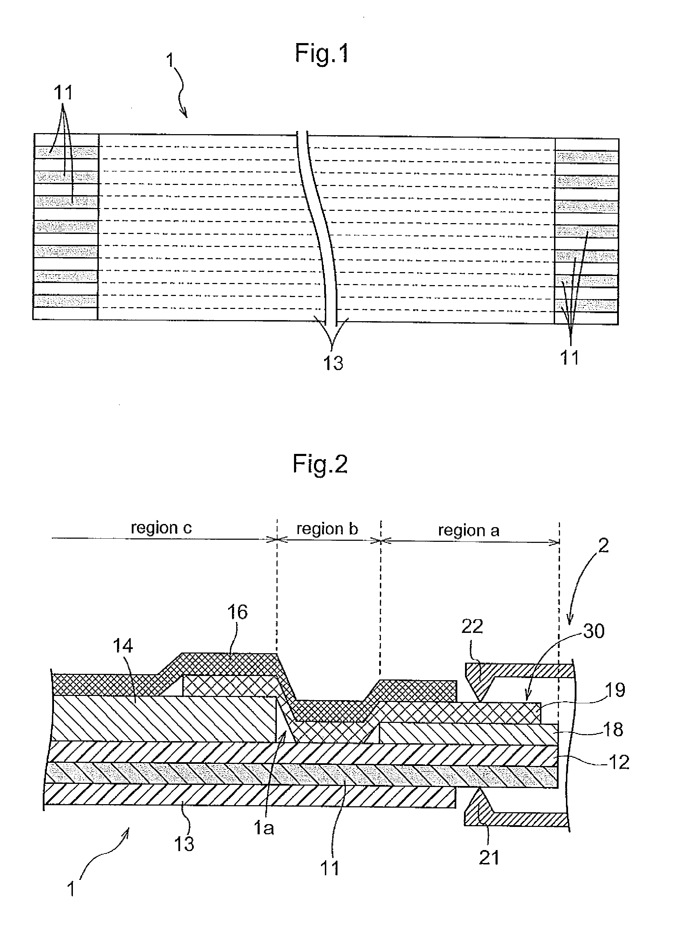

Next, embodiments of a flexible flat cable (to be referred to as the "flat cable 1" hereinafter) according to the present invention will be described with reference to the accompanying drawings. Fig. 1 is a plane view of the flat cable 1 as seen from the side of a second insulator layer 13 to be described later, and Fig. 2 is a section view showing the vicinity of an end of the flat cable 1.

As shown in Fig. 1, the flat cable 1 includes a plurality of linear or line-like conductors 11 arranged in parallel with each other. These conductors 11 each forms a signal line for transmitting signals. The number of conductors 11 will be determined in accordance with the specification of signals to be transmitted. As the material forming the conductors 11, a material having high conductivity and flexibility such as copper is preferred. Further, as these conductors 11, a plurality of linear conductors may be employed or the conductors may be formed as a plurality of linear portions formed by e.g. etching a conductive foil formed on a highly flexible substrate.

Further, as shown in Fig. 2, the conductors 11 are sandwiched between a first insulator layer 12 and the second insulator layer 13 and covered/shielded thereby. As material forming the first insulator layer 12 and the second insulator layer 13, a polyester resin can be used. Incidentally, in the following discussion, with using the illustration in Fig. 2 as a reference, the side of the conductor 11 on the side of the first insulator layer 12 will be referred to as the upper side and the side thereof on the side of the second insulator layer 13 will be referred to as the lower side, respectively.

As shown, the length of the first insulator layer 12 is same as the length of the conductors 11, whereas the length of the second insulator layer 13 is shorter than the length of the conductors 11. Thus, at the end of the flat cable 1, the conductors 11 are covered by the first insulator layer 12, but not covered by the second insulator layer 13. That is, the conductors 11 remain exposed at the end of the flat cable 1 to the lower side (to the side of the second insulator layer 13).

Upwardly of the first insulator layer 12, there is provided a first adjustment material layer 14 having insulating property. This first adjustment material layer 14 is spaced from the end of the flat cable 1 with a predetermined distance. More particularly, between the first adjustment material layer 14 and the end of the flat cable 1, a gap is formed. Incidentally, in the following discussion, the portion where the first adjustment material layer 14 is provided will be referred to as the "region (c)".

Further, upwardly of the first insulator layer 12 ,there is provided a reinforcement plate 18 for increasing the strength of the end of the flat cable 1. This reinforcement plate 18 is provided at the gap between the first adjustment material layer 14 and the end of the flat cable 1. In the case of the flat cable 1 according to the present embodiment, the reinforcement plate 18 and the first adjustment material layer 14 are not in contact with each other, but a gap 1a is formed between the reinforcement plate 18 and the first adjustment material layer 14. Incidentally, in the following discussion, the portion where the reinforcement plate 18 is provided will be referred to as the "region (a)" and the portion where the gap 1a is formed will be referred to as the "region (b)", respectively.

It is understood, however, that this gap 1a between the reinforcement plate 18 and the first adjustment material layer 14 is not an essential requirement. This may be omitted if the flat cable 1 can be manufactured so as not to form such gap 1a.

From the upper side of the reinforcement plate 18 to the upper side of the end of the first adjustment material layer 14, there is provided a conductive shield member 19. This shield member 19 is provided at a position slightly retracted from the end so as no to protrude beyond the end of the flat cable 1. As described above, the gap 1a is present between the reinforcement plate 18 and the first adjustment material layer 14 and this gap 1a together with the first insulator layer 12 form a recess. Therefore, in the region (b), the shield member 19 is bent downwards so as to follow the contour of the recess and contacts the first insulator layer 12 which forms the bottom of this recess.

Further, from the upper side of the shield member 19 to the upper side of the first adjustment material layer 14, there is provided a first shield layer 16 having conductivity. This first shield layer 16 is provided at a position spaced from the end of the flat cable 1 by a predetermined distance. Therefore, the first adjustment material layer 14 as a whole is covered by the first shield layer 16, but the upper side of the shield member 19 on the side of the end of the flat cable 1 remains exposed.

To the end of the flat cable 1 configured as described above, a connector 2 is connected. This connector 2 includes signal terminals 21 to be connected to the conductors 11 and a ground terminal 22 for transmitting a ground potential. As described above, each conductor 11 is exposed on the lower side thereof, whereas the shield member 19 is exposed on the upper side thereof. From the upper side, the ground terminal 22 comes into contact with the shield member 19 and from the lower side, the signal terminals 21 come into contact with the conductors 11. Therefore, as shown, the signal terminals 21 and the ground terminal 22 can be disposed at positions in opposition to each other. With this, the clamping force applied from the signal terminal 21 to the flat cable 1 and the clamping force applied from the ground terminal 22 to the flat cable 21 act in opposition to each other. Therefore, easy inadvertent detachment of the connector 2 can be effectively prevented.

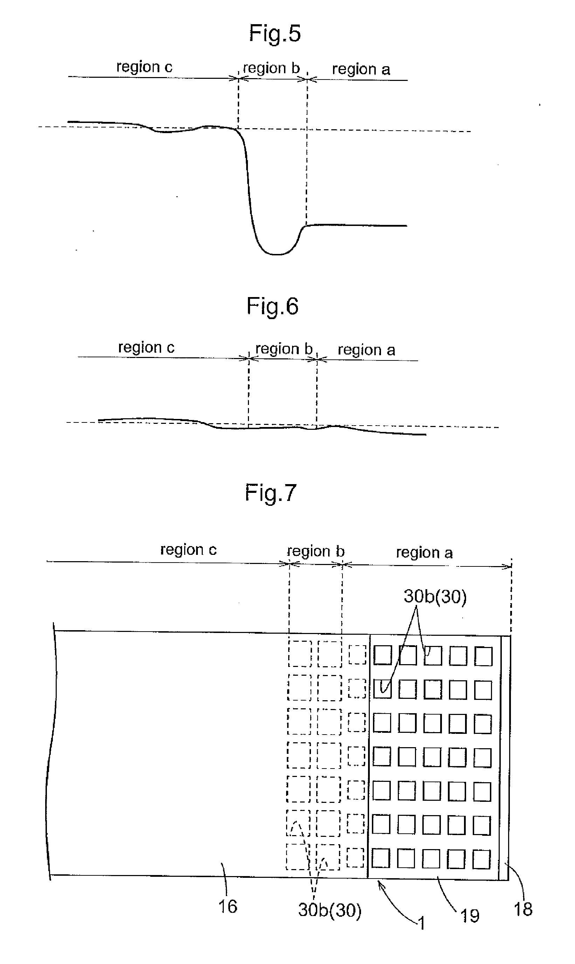

With the flat cable 1 configured as described above, as shown in Fig. 5, there occurs impedance change or variation in the regions (a), (c). Specifically, the impedance in the region (a), i.e. the vicinity of the end of the flat cable 1 is lower than the impedance in the region (c), i.e. the vicinity of the center portion of the flat cable 1. Such reduction in the impedance in the vicinity of the end of the flat cable 1 is not desirable, in particular in the case of high speed transmission such as described above.

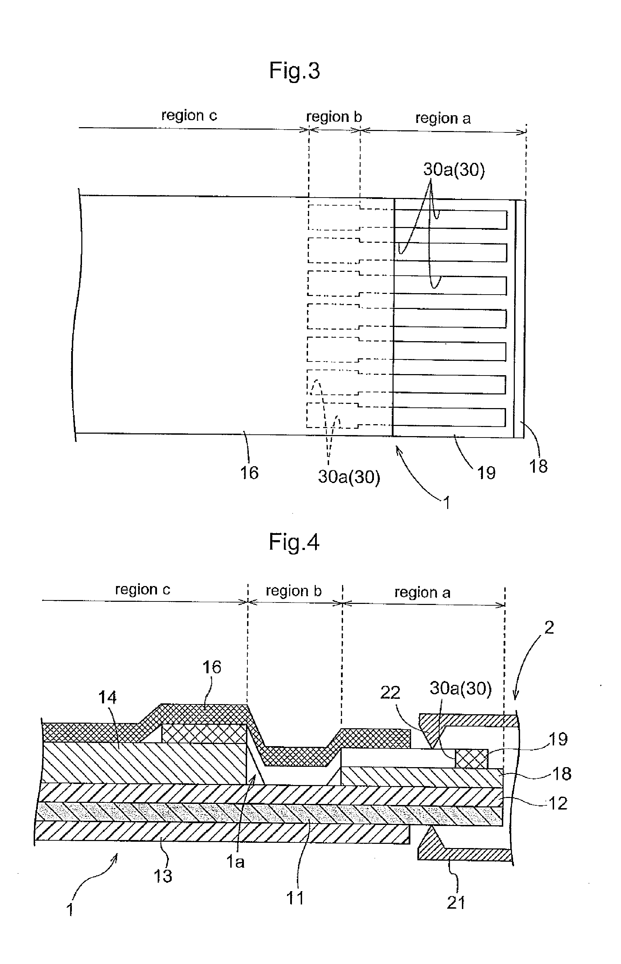

To cope with the above, the shield member 19 of the inventive flat cable 1 is provided with an impedance adjusting means 30. Fig. 3 is a plane view showing the vicinity of the end of the flat case 1 as seen from the upper side, that is, from the first insulator layer 12 side. In this illustration, as the impedance adjusting means, slits 30a (an example of "a through hole" in the present invention) are provided. Each slit 30a is arranged so as to extend through the shield member 19 in the regions (a), (b) from the first shield layer 16 side to the reinforcement plate 18 side. Fig. 4 is a section view of the flat cable 1 in section along the sectional line extending through the slit 30a. This view shows the condition of the slit 30a.

With provision of a through hole like the slits 30a in the shield member 19 as described above, this effectively reduces the surface area of the upper side of the shield member 19, that is, the surface area of the side to which the ground terminal 22 comes into contact. Therefore, in the vicinity of the region of the reduced surface area in the upper side of the shield member 19, the impedance is increased. With this, it becomes possible to restrict occurrence of impedance reduction in the vicinity of the end of the flat cable 1.

Further, as described above, in the flat cable 1 according to this embodiment, in the region (b), the shield member 19 contacts the first insulator layer 12. Accordingly, as shown in Fig. 5, the impedance reduction in the region (b) is greater than the impedance reduction in the area (a). Therefore, in the instant embodiment, as shown in Fig. 3, the decrease rate of the surface area of the shield member 19 in the region (a) is set greater than the decrease rate of the surface area of the shield member 19 in the region (b). Specifically, the width of the slit 30a in the region (a) is set greater than the width of the slit 30a in the region (b).

As described above, with the provision of the slits 30a in the shield member 19, the impedances in the respective regions become as illustrated in Fig. 6. Hence, it may be seen that as compared with the arrangement without such slits 30a, the change in the impedances approaches flat.

The positions where the slits 30a are formed can vary as desired. It is preferred, however, that the slits 30a be formed so as to be overlapped with the conductors 11 as seen in the plane view. Incidentally, in Fig. 3, for the sake of ease of visual understanding, illustration of the conductors 11 is omitted. However, the slits 30a are formed so as to be overlapped with the conductors 11 as seen in the plane view. Also, in practice, as shown in Fig. 4, the conductors 11 extend from one end of the flat cable 1 to the other end thereof. Also, the size of the slit 30a can be variably set in accordance with the magnitude of the impedance to be adjusted thereby.

Further, the shape of the through hole as the impedance adjusting means 30 is not limited to the slit, but can vary in many ways. For instance, as shown in Fig. 7, rectangular holes 30b (another example of the "through hole" in the present invention) as the impedance adjusting means 30 can be provided in a matrix pattern.

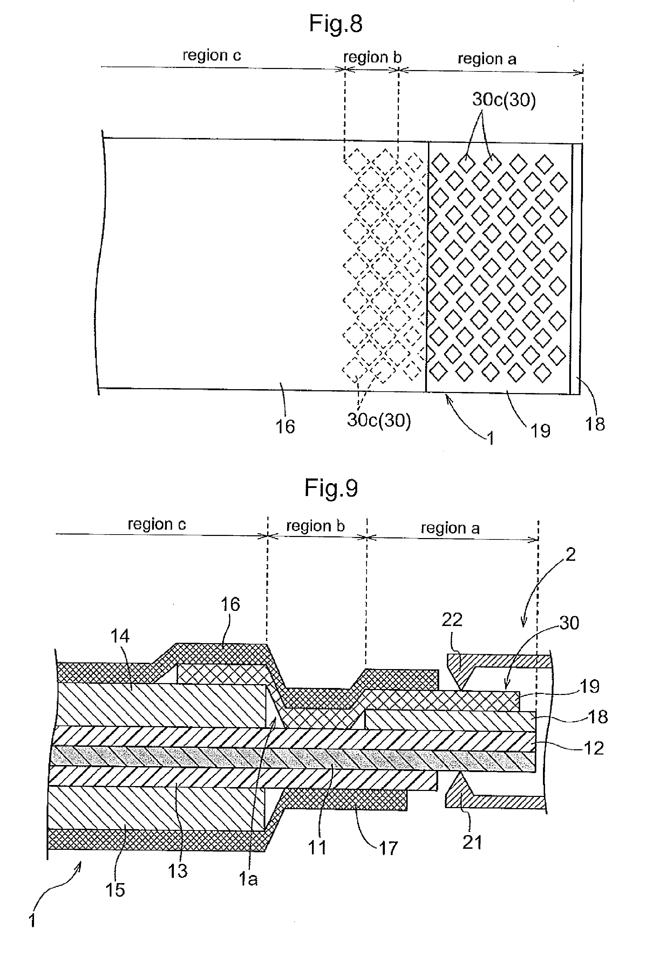

Further alternatively, as shown in Fig. 8, rhombus-shaped holes 30c (another example of the "through hole" in the present invention) as the impedance adjusting means 30 can be provided in a checkerboard pattern.

Needless to say, the shape and layout of the through holes as the impedance adjusting means 30 are not limited to the above, but various modifications thereof are possible as long as such modifications too achieve the intended object of the invention. Incidentally, in these modified examples of "through holes" too, it is preferred that the through holes be overlapped with the conductors 11 as seen in the plane view. It is also preferred that the aperture area of the through hole(s) in the region (b) be greater than the aperture area of the through hole(s) in the region (a).

Also, the impedance adjusting means 30 is not limited to the through holes. For instance, an insulation layer may be formed in the shield member 19. I this case, the insulation layer can have a similar shape to the above-described through hole.

In the foregoing embodiment, the adjustment material layer (the first adjustment material layer 14) and the shield layer (the first shield layer 16) are provided only on the side of the first insulation material layer 12. Instead, as shown in Fig. 9, a second adjustment material layer 15 may be provided under the insulation material layer 13 and a second shield layer 17 may be provided under the second adjustment material layer 15. Incidentally, preferably, the second shield layer 17 is arranged so as to cover the end of the second adjustment material layer 15. Further, the second shield layer 17 is formed shorter than the second insulation material layer 13, so that the end of the second insulation material layer 13 is exposed.

Incidentally, in Fig. 2, Fig. 4 and Fig. 9, the junction portion between the region (b) and the region (c) (the inclined layer portion) seems to be of a different layer thickness from the flat portions. However, unless indicated otherwise, the thickness is constant throughout all the regions or portions.

The present invention is applicable to a flexible flat cable.

## Claims

1. A flexible flat cable (1) comprising:
a first sheet-like insulator layer (12);
a second sheet-like insulator layer (13) disposed in opposition to the first insulator layer (12); and
a plurality of linear conductors (11) disposed in parallel with each other between the first insulator layer (12) and the second insulator layer (13);
**characterized in that**
the flexible flat cable (1) comprises:
a first adjustment material layer (14) disposed on the side of the first insulator layer (12) opposite the conductors (11) and spaced from an end of the flexible flat cable (1) with a predetermined distance;
a reinforcement plate (18) provided on the side of the first insulator layer (12) opposite the conductors (11) and between the end of the flexible flat cable (1) and the first adjustment material layer (14);
a shield member (19) disposed so as to cover the side of the reinforcement plate (18) opposite the first insulator layer (12) and the side of the first adjustment material layer (14) opposite the first insulator layer (12);
a first shield layer (16) disposed from the side of the shield member (19) opposite the reinforcement plate (18) to the side of the first adjustment material layer (14) opposite the first insulator layer (12), with exposing a portion of the side of the shield member (19) opposite the reinforcement plate (18);
wherein the second insulator layer (13) is arranged to expose the conductors (11) at the end of the flexible flat cable (1);
the exposed conductors (11) and the exposed shield member (19) come into contact with signal terminals (21) and a ground terminal (22) of a connector (2); and
the shield member (19) includes an impedance adjusting means (30).

2. The flexible flat cable according to claim 1, **characterized in that** the impedance adjusting means (30) is configured to decrease the surface area of the side of the shield member (19) opposite the reinforcement plate (18).

3. The flexible flat cable according to claim 2, **characterized in that**:
a gap (1a) is formed between the reinforcement plate (18) and the first adjustment material layer (14);
the shield member (19) comes into contact with the first insulator layer (12) at the gap (1a); and
the rate of decrease in the area at the gap (1a) is set greater than the rate of decrease in the area at the portion of the shield member (19) covering the reinforcement member (18),

4. The flexible flat cable according to claim 2 or 3, **characterized in that** the decrease of the area of the shield member (19) is realized by formation of a through hole (30a, 30b, 30c) extending through the shield member (19).

5. The flexible flat cable according to claim 4, **characterized in that** the through hole (30a, 30b, 30c) is formed at the position overlapped with the conductors (11) as seen in the plane view.

6. The flexible flat cable according to any one of claims 1-5, **characterized in that** the flexible flat cable further comprise:
a second adjustment material layer (15) provided on the side of the second insulator layer (13) opposite the conductors (11) and spaced from the end of the flexible flat cable (1) with a predetermined distance; and
a second shield layer (17) provided on the side of the second adjustment material layer (15) opposite the second insulator layer (13) and spaced from the end of the flexible flat cable (1) with a predetermined distance.
